# EUROPEAN PATENT APPLICATION

(11) **EP 4 369 403 A1**
(43) Date of publication of application: **15.05.2024**
(21) Application number: 21949703.9
(22) Date of filing: 16.07.2021
(51) Int. Cl.: H01L 27/146, H04N 25/70

(54) **IMAGE SENSOR AND ELECTRONIC DEVICE**

(71) Applicant: Huawei Technologies Co., Ltd., Longgang Shenzhen, Guangdong 518129 (CN)
(72) Inventor: LIU, Yongjun, Shenzhen, Guangdong 518129 (CN); YANG, Liang, Shenzhen, Guangdong 518129 (CN)
(74) Representative: Huawei European IPR
(86) International application number: PCT/CN2021/106697
(87) International publication number: WO 2023/283919

(57) **Abstract**

Embodiments of this application provide an image sensor and an electronic device, to increase photosensibility, improve utilization of light that is incident to the image sensor, and reduce crosstalk between bands. The image sensor includes at least one photosensitive pixel. Each photosensitive pixel includes a plurality of nano antenna layers. The plurality of nano antenna layers are arranged in an overlapping manner. Each nano antenna layer includes at least one nano antenna. The at least one nano antenna is configured to generate resonance for incident light. Different nano antenna layers generate resonance for incident light of different bands or different polarization directions. An output signal of the nano antenna layers is used to obtain an image.

## Description

### TECHNICAL FIELD

This application relates to the imaging field, and in particular, to an image sensor and an electronic device.

### BACKGROUND

Color image sensors have been widely used in fields such as consumers and security protection. Currently, there are two technical development trends: one is resolution improvement, which means that a pixel size is reduced when a photosensitive area is limited; and the other one is enhancement of a photosensitive capability, which meets a requirement of low-light photographing.

A stacked image sensor implements stacked multi-color pixels based on different penetration depths of light of different colors in a photosensitive layer. To be specific, each pixel of the sensor is divided into three layers that are sequentially blue, green, and red from top to bottom. However, light may be absorbed to some extent in a penetration process, and therefore, a problem of high crosstalk is caused, especially crosstalk of long-wavelength light to a short-wavelength light detection signal, for example, crosstalk of red and green light to a blue light detection signal. Therefore, how to reduce crosstalk between light of each band becomes an urgent problem to be resolved.

### SUMMARY

Embodiments of this application provide an image sensor and an electronic device, to increase photosensibility, improve utilization of light that is incident to the image sensor, and reduce crosstalk between incident light of each band.

In view of this, according to a first aspect, this application provides an image sensor. The image sensor includes at least one photosensitive pixel. Each photosensitive pixel includes a plurality of nano antenna layers. The plurality of nano antenna layers are arranged in an overlapping manner. Each nano antenna layer includes at least one nano antenna. The at least one nano antenna is configured to generate resonance for incident light. Different nano antenna layers are configured to generate resonance for different incident light. An output signal of the nano antennas is used to obtain an image. The different incident light includes light of different bands, light of different polarization directions, or the like.

In the image sensor provided in this application, resonance is generated for incident light through a nano antenna, to obtain an electrical signal. Compared with disposing a plurality of photosensitive layers, in this application, resonance is generated for incident light through a nano antenna, so that absorption of the incident light can be enhanced, and crosstalk of incident light of each band can be reduced. In addition, a thickness is less than a thickness of a common photosensitive layer. Therefore, in this application, compared with disposing a plurality of photosensitive layers, a smaller nano antenna may be used to reduce a thickness of an antenna layer that absorbs all bands, thereby reducing crosstalk between light of each band, and improving utilization of light.

In a possible implementation, the image sensor further includes a plurality of pins. The plurality of pins are in contact with the at least one photosensitive pixel, and are configured to receive an electrical signal output by the at least one photosensitive pixel. The electrical signal is used to obtain an image. Therefore, in this implementation of this application, an output signal of each photosensitive pixel may be transmitted through a pin, to obtain output of the image sensor.

In a possible implementation, the nano antenna includes a material that can generate a plasmon signal with light. The at least one nano antenna is configured to generate resonance for incident light to generate a plasmon signal. The plasmon signal is used to generate an electrical signal. Therefore, in this implementation of this application, resonance for the incident light may be implemented by referring to a plasmon effect of a relatively small nano antenna and the incident light. Compared with directly disposing a photosensitive layer, the nano antenna may absorb the incident light through resonance, thereby improving utilization of the incident light, and reducing crosstalk of incident light of each band on the basis that the nano antenna absorbs more incident light.

In a possible implementation, there is a positive correlation relationship between a thickness of each nano antenna layer and a wavelength of an output signal generated by each nano antenna layer. In this implementation of this application, there is a positive correlation relationship between the thickness of each antenna layer and the wavelength. Therefore, in an actual application scenario, a matched antenna layer thickness may be selected based on a wavelength that needs to be absorbed, to adapt to various scenarios.

In a possible implementation, each nano antenna layer further includes a photoelectric sensing structure. The photoelectric sensing structure is in contact with at least one surface of the at least one nano antenna. The photoelectric sensing structure is configured to convert plasmon signals on the plurality of nano antennas into electrical signals. Therefore, in this implementation of this application, the photoelectric sensing structure may be disposed in the nano antenna layers, so that a plasmon signal can be directly converted into an electrical signal in each nano antenna layer, and the electrical signal is output through a pin.

Optionally, the photoelectric sensing structure may be in contact with one surface of the nano antennas, or may wrap the nano antennas.

In a possible implementation, a selection layer is further disposed between adjacent nano antenna layers of the plurality of nano antenna layers. The selection layer is configured to filter incident light transmitted between the adjacent nano antenna layers.

Therefore, in this implementation of this application, crosstalk between incident light that is of different bands and that is absorbed between the layers may be reduced by disposing the selection layer, and quality of a finally obtained output image is improved.

In a possible implementation, the selection layer is disposed in a first nano antenna layer and a second nano antenna layer. The first nano antenna layer and the second nano antenna layer are two adjacent layers of the plurality of nano antenna layers. A transmission direction of the incident light is that the incident light is transmitted from the first nano antenna layer to the second nano antenna layer. The selection layer includes at least two materials with different refractive indexes. The selection layer is configured to reflect light of a first band and transmit light of a second band. The first band is a band of resonated incident light in the first nano antenna layer. The second band is a band of resonated incident light in the second nano antenna layer.

Therefore, in this implementation of this application, the selection layer may reflect light of a band absorbed by an upper layer, and transmit light of a band absorbed by a lower layer, to reduce a light intake transmitted to the lower layer of the light of the band absorbed by the upper layer, thereby reducing crosstalk between light of different bands absorbed by the layers.

In a possible implementation, each nano antenna layer includes a plurality of nano antenna sublayers. Each nano antenna sublayer includes at least one nano antenna. Nano antennas in the plurality of nano antenna sublayers generate resonance for incident light of a same band.

Therefore, in this implementation of this application, the plurality of nano antenna sublayers are disposed in each nano antenna layer, and the plasmon effect is enhanced through a coupling effect, thereby increasing photosensibility of incident light, and improving absorption of incident light.

In a possible implementation, in two adjacent nano antenna layers of the plurality of nano antenna layers, a thickness of a nano antenna layer arranged above is not greater than a thickness of a nano antenna layer arranged below.

Therefore, thicknesses of the antenna layers are also arranged in a sequence from thin to thick, so that light of a short wavelength may be absorbed first, crosstalk between incident light of all wavelengths may be avoided, and absorption strength of light of each band is increased.

It should be understood that, in this implementation of this application, an incident direction of the incident light may be understood as from top to bottom. The bottom is a direction away from an incident light source, and the top is a direction close to the incident light source.

In a possible implementation, a wavelength of resonated incident light in the nano antenna layer arranged above (namely, a wavelength for generating resonance) is not greater than a wavelength of incident light for which a nano antenna in the nano antenna layer arranged below generates resonance.

Therefore, in this implementation of this application, the nano antennas from top to bottom may be arranged in ascending order of absorption wavelengths, namely, wavelengths of resonated incident light. Correspondingly, thicknesses of the antenna layers are also arranged in ascending order of thicknesses. Therefore, light of a short wavelength may be absorbed first, and wavelengths of the absorbed light may be gradually increased, so that crosstalk between incident light of all wavelengths can be avoided, and absorption strength of light of each band can be increased.

In a possible implementation, the image sensor may further include a photoelectric sensing layer. The photoelectric sensing layer is disposed below the plurality of nano antenna layers. The photoelectric sensing layer is configured to convert an output signal generated by the plurality of nano antenna layers into an electrical signal.

Therefore, in this implementation of this application, the photoelectric sensing layer may be separately disposed, so that the plasmon signal is converted into an electrical signal through the photoelectric sensing layer.

In a possible implementation, one end of the at least one nano antenna included in each nano antenna layer is connected to one end of a waveguide, and the other end of the waveguide is connected to the photoelectric sensing layer. The output signal generated by the at least one nano antenna is transmitted to the photoelectric sensing layer through the waveguide. In this implementation of this application, a specific implementation of separately disposing the photoelectric sensing layer is provided, so that the plasmon signal on the nano antenna can be transmitted to the photoelectric sensing layer through the waveguide.

In a possible implementation, a vertical distance between nano antennas included in two adjacent nano antenna layers of the plurality of nano antenna layers is not less than one tenth of a wavelength of resonated incident light in any one of the two adjacent nano antenna layers. Therefore, in this implementation of this application, the vertical distance between the nano antennas included in the antenna layers is not less than one tenth of the wavelength of the light absorbed by the two adjacent nano antenna layers, to avoid a coupling effect caused by an excessively close distance between the nano antennas included in the layers.

In a possible implementation, in two adjacent nano antenna layers of the plurality of nano antenna layers, a wavelength of incident light for which a nano antenna in a nano antenna layer arranged above generates resonance is greater than a wavelength of incident light for which a nano antenna in a nano antenna layer arranged below generates resonance.

In this implementation of this application, if the photoelectric sensing layer is separately disposed, a wavelength absorbed by the nano antenna in the nano antenna layer arranged above is greater than a wavelength absorbed by the nano antenna in the nano antenna layer arranged below, so that a loss during signal transmission through the waveguide can be reduced, and utilization of light can be improved.

In a possible implementation, two adjacent nano antenna layers may include antennas that are of a same shape, and the same-shaped antennas have different polarization directions. Therefore, in this implementation of this application, the antenna layers may be separately disposed for light that is of a same band but different polarizations, to absorb the light of different polarizations, thereby improving utilization of the light.

In a possible implementation, if the foregoing antenna is a dipole antenna, dipole antennas in two adjacent nano antenna layers have different extension directions; or if the foregoing at least one nano antenna is a spiral antenna, spiral antennas in two adjacent nano antenna layers have different rotation directions.

In this implementation of this application, the nano antennas may use a plurality of manners, and antenna polarization directions of two adjacent layers of nano antennas are different, so that a coupling effect between antennas in adjacent layers can be avoided, absorption rates of light of different bands or different polarizations can be improved, and utilization of light can be improved.

According to a second aspect, this application provides an electronic device. The electronic device includes the image sensor in the first aspect or any implementation of the first aspect.

### BRIEF DESCRIPTION OF DRAWINGS

FIG. 1 is a schematic diagram of a structure of an electronic device according to an embodiment of this application;
FIG. 2 is a schematic diagram of a structure of an image sensor according to an embodiment of this application;
FIG. 3 is a schematic diagram of a structure of another image sensor according to an embodiment of this application;
FIG. 4 is a schematic diagram of a structure of an antenna according to an embodiment of this application;
FIG. 5 is a schematic diagram of a structure of another antenna according to an embodiment of this application;
FIG. 6 is a schematic diagram of a structure of another image sensor according to an embodiment of this application;
FIG. 7 is a schematic diagram of a structure of another image sensor according to an embodiment of this application;
FIG. 8 is a schematic diagram of a structure of another image sensor according to an embodiment of this application;
FIG. 9 is a schematic diagram of a structure of another image sensor according to an embodiment of this application;
FIG. 10 is a schematic diagram of a structure of another image sensor according to an embodiment of this application;
FIG. 11 is a schematic diagram of a structure of another image sensor according to an embodiment of this application;
FIG. 12 is a schematic diagram of a structure of another image sensor according to an embodiment of this application; and
FIG. 13 is a schematic diagram of a structure of another image sensor according to an embodiment of this application.

### DESCRIPTION OF EMBODIMENTS

The following describes the technical solutions in embodiments of this application with reference to the accompanying drawings in embodiments of this application. It is clear that the described embodiments are merely some rather than all of embodiments of this application. All other embodiments obtained by a person skilled in the art based on embodiments of this application without creative efforts shall fall within the protection scope of this application.

In the specification, claims, and accompanying drawings of this application, terms "first", "second", "third", "fourth", and the like (if existent) are intended to distinguish between similar objects but do not necessarily indicate a specific order or sequence. It should be understood that the data termed in such a way are interchangeable in proper circumstances, so that embodiments described herein can be implemented in other orders than the order illustrated or described herein. Moreover, the terms "include", "contain", and any variant thereof are intended to cover a non-exclusive inclusion. For example, a process, method, system, product, or device that includes a list of steps or units is not necessarily limited to those steps or units that are expressly listed, but may include other steps or units that are not expressly listed or are inherent to the process, method, product, or device.

In the description of this application, "a plurality of" means two or more than two, unless otherwise specifically limited.

In this application, unless otherwise specified and limited, the terms such as "install", "connect to", "connection", "fasten", and "dispose" should be understood in a broad sense. For example, such terms may indicate a fixed connection, a detachable connection, or an integration; may indicate a mechanical connection or an electrical connection; or may indicate a direct connection, an indirect connection through an intermediate medium, or an internal connection between two elements or an interaction relationship between two elements. A person of ordinary skill in the art may understand specific meanings of the foregoing terms in this application according to specific cases.

In the description of this application, it should be understood that an orientation or a position relationship indicated by the terms "length", "width", "upper", "lower", "front", "rear", "left", "right", "vertical", "horizontal", "top", "bottom", "inside", "outside", or the like is an orientation or position relationship shown in the accompanying drawings, and is merely intended to facilitate description and simplify description of this application, but is not intended to indicate or imply that an apparatus or element in question needs to have a specific orientation or needs to be constructed and operated in a specific orientation. Therefore, such terms cannot be construed as a limitation on this application.

Some terms are used in this specification and the claims to refer to specific components. A person skilled in the art should understand that a same component may be named differently by hardware manufacturers. In this specification and the subsequent claims, components are distinguished between each other based on functional differences, instead of naming differences. The terms "include" and "comprise" mentioned in this specification and the claims are open terms and should be construed as "include but is not limited to" or "comprise but is not limited to".

First, for ease of understanding, some terms used in this application are described.

Plasmon effect: In a solid system with a specific carrier concentration (such as metal and a semiconductor with a specific carrier concentration), due to a Coulomb interaction between carriers, a fluctuation of the carrier concentration at one location in space causes oscillation of the carrier concentration at other locations. This elementary excitation characterized by the oscillation of the carrier concentration is called a plasmon effect.

The following describes technical solutions of this application with reference to accompanying drawings.

The electronic device in embodiments of this application may include a handheld device, a vehicle-mounted device, a wearable device, a computing device, or another processing device connected to a wireless modem. The electronic device may further include a digital camera (digital camera), a cellular phone (cellular phone), a smartphone (smartphone), a personal digital assistant (personal digital assistant, PDA) computer, a tablet computer, a laptop computer (laptop computer), a machine type communication (machine type communication, MTC) terminal, a point of sales (point of sales, POS), a vehicle-mounted computer, a head-mounted device, a wearable device (such as a wristband or a smartwatch), a security protection device, a virtual reality (virtual reality, VR) device, an augmented reality (augmented reality, AR) device, and another electronic device having an imaging function.

A digital camera is used as an example. The digital camera is an abbreviation of a digital still camera, and is a camera that converts an optical image into a digital signal by using a photoelectric sensor. Unlike a traditional camera that relies on changes in a photosensitive chemical on film to record an image, a sensor of the digital camera is a photosensitive charge-coupled device (charge-coupled device, CCD) or a complementary metal oxide semiconductor (complementary metal oxide semiconductor, CMOS). Compared with the traditional camera, the digital camera has the advantages of being more convenient, faster, repeatable, more timely, and the like because of direct use of the photoelectric conversion image sensor. With the development of a CMOS processing technology, the digital camera has more powerful functions and has almost completely replaced the traditional film camera. The digital camera is widely used in fields such as consumer electronics, security protection, human-machine interaction, computer vision, and self-driving.

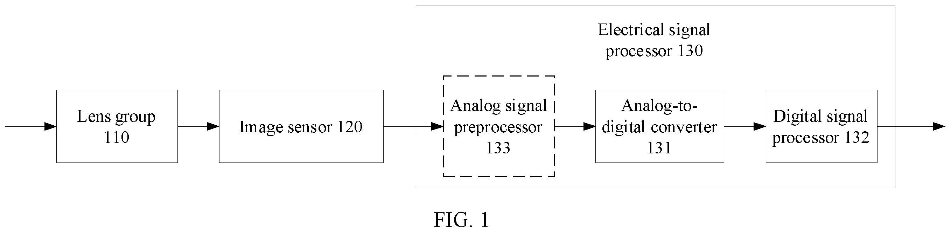

FIG. 1 shows a schematic diagram of an electronic device according to this application. As shown in the figure, the electronic device may include a lens (lens) group 110, an image sensor (sensor) 120, and an electrical signal processor 130. The electrical signal processor 130 may include an analog-to-digital (A/D) converter 131 and a digital signal processor 132. The analog-to-digital converter 131 is an analog signal-to-digital signal converter, and is configured to convert an analog electrical signal into a digital electrical signal.

It should be understood that the electronic device shown in FIG. 1 is not limited to the foregoing components, and may further include more or fewer other components such as a battery, a flash, a button, and a sensor. In this embodiment of this application, only an electronic device on which the image sensor 120 is installed is used as an example for description, but an element installed on the electronic device is not limited thereto.

An optical signal reflected by a photographed object is converged through the lens group 110, and is imaged on the image sensor 120. The image sensor 120 converts the optical signal into an analog electrical signal. The analog electrical signal is converted into a digital electrical signal through the analog-to-digital (A/D) converter 131 in the electrical signal processor 130, and the digital electrical signal is processed through the digital signal processor 132. For example, the data electrical signal is optimized through a series of complex mathematical algorithm operations, and finally an image is output. The electrical signal processor 130 may further include an analog signal preprocessor 133, configured to preprocess the analog electrical signal transmitted by the image sensor and output a preprocessed analog electrical signal to the analog-to-digital converter 131.

Performance of the image sensor 120 affects quality of the finally output image. The image sensor 120 may also be referred to as a photosensitive chip, a photosensitive element, or the like, and includes hundreds of thousands to millions of photoelectric conversion elements. When being irradiated by light, the image sensor 120 generates a charge, and converts the charge into a digital signal through an analog-to-digital converter chip. The image sensor, namely, the photosensitive element including a plurality of pixels, implements imaging through a photoelectric response.

For example, a stacked image sensor implements stacked multi-color pixels based on different penetration depths of light of different colors in a photosensitive layer. To be specific, each pixel of the sensor is divided into three layers that are sequentially blue, green, and red from top to bottom. However, light may be absorbed to some extent in a penetration process, and therefore, a problem of high crosstalk is caused, especially crosstalk of long-wavelength light to a short-wavelength light detection signal. For example, absorption of blue light by red and green light in incident light causes crosstalk.

Therefore, this application provides an image sensor, to reduce crosstalk between different color detection signals, and enhance an absorption rate of light, so that output data of the image sensor is more accurate. Even in a case of low illumination, a clearer image can be obtained. The following describes a structure of the image sensor provided in this application.

The image sensor may include at least one photosensitive pixel. Each photosensitive pixel includes a plurality of nano antenna layers. The plurality of nano antenna layers are arranged in an overlapping manner. Each nano antenna layer includes at least one nano antenna. The at least one nano antenna is configured to generate resonance for incident light. Nano antennas included in a same nano antenna layer generate resonance for incident light of a same band, and different nano antenna layers generate resonance for different incident light. The different incident light includes light of different bands or light that is of a same band but that is of different resonance directions. An output signal of the nano antennas is used to obtain an image.

In this implementation of this application, the nano antenna layers are disposed, and the nano antennas are formed by using a material that can generate a plasmon effect, so that a stronger focusing effect is generated on incident light. Therefore, stronger absorption of the incident light is implemented by using a smaller antenna layer size. Compared with disposing a photoelectric sensing layer separately, stronger absorption of the incident light can be implemented. In addition, a thickness of a photoelectric absorption material is reduced, so that crosstalk between bands can be reduced.

In a possible implementation, the image sensor further includes a plurality of pins. The plurality of pins are in contact with the at least one photosensitive pixel, and are configured to receive an electrical signal output by the at least one photosensitive pixel. The electrical signal is used to obtain an image. Therefore, in this implementation of this application, an output signal of each photosensitive pixel may be transmitted through a pin, to obtain output of the image sensor.

In a possible implementation, the nano antenna includes a material that can generate a plasmon signal with light. The at least one nano antenna is configured to generate resonance for incident light to generate a plasmon signal. The plasmon signal is used to generate an electrical signal. Therefore, in this implementation of this application, resonance for the incident light may be implemented by referring to a plasmon effect of a small nano antenna and the incident light. Compared with directly disposing a photosensitive layer, the nano antenna may absorb the incident light through resonance, thereby improving utilization of the incident light, and reducing crosstalk of incident light of each band on the basis that the nano antenna absorbs more incident light.

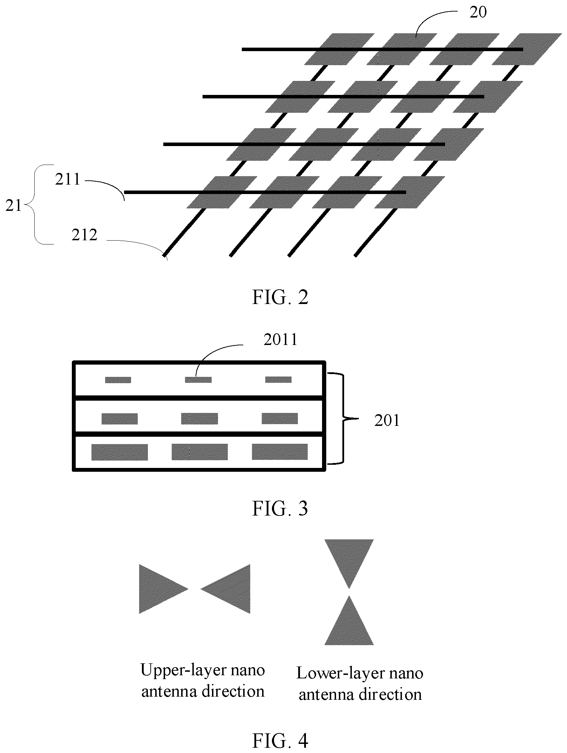

The following describes in detail the image sensor provided in this application. For example, FIG. 2 is a schematic diagram of a structure of an image sensor according to this application.

The image sensor may include at least one photosensitive pixel 20 and a plurality of pins 21.

FIG. 2 shows a plurality of photosensitive pixels. When there are a plurality of photosensitive pixels, the plurality of photosensitive pixels are arranged in a form of an array to form a photosensitive pixel array. The plurality of pins are in contact with the plurality of photosensitive pixels. The plurality of pins are configured to output electrical signals generated by the plurality of photosensitive pixels. The electrical signals are used to obtain an image.

For example, as shown in FIG. 2, the plurality of photosensitive pixels are arranged in a form of a matrix array. The plurality of pins may be divided into row pins 211 and column pins 212. The row pins may be in contact with upper surfaces of each row of photosensitive pixels, and the column pins may be in contact with each column of photosensitive pixels. To be specific, each photosensitive pixel may be connected to a row pin or a column pin, so that an electrical signal generated by each photosensitive pixel can be output through the pin.

Specifically, as shown in FIG. 3, each photosensitive pixel includes a plurality of nano antenna layers 201. The plurality of nano antenna layers 201 are arranged in an overlapping manner. Each nano antenna layer may include at least one nano antenna 2011, configured to generate resonance for light of a specific wavelength or a specific polarization to generate a plasmon signal. Different nano antenna layers may generate resonance for different incident light. The difference means different bands or resonance directions of the incident light. The plasmon signal is converted into an electrical signal, and then the electrical signal is output through a pin that is in contact with the photosensitive pixel.

It should be noted that, in the following implementations of this application, for example, each nano antenna layer includes a plurality of nano antennas that may alternatively be replaced with at least one nano antenna. Details are not described below again.

In this implementation of this application, a part that is of incident light and that generates resonance with the nano antenna is absorbed by the nano antenna and forms a plasmon signal on a surface. The plasmon signal may be converted into an electrical signal through a photoelectric sensing material, and then is output through a pin. Therefore, a thickness of the photoelectric absorption material may be greatly reduced through a strong focusing function of the nano antenna, thereby reducing absorption of crosstalk light. In addition, a wavelength selection function of the nano antenna also reduces the absorption of crosstalk light, thereby achieving an effect of greatly reducing crosstalk. In addition, because of the strong focusing function of the nano antenna, a light absorption function is enhanced, and photosensibility is improved, so that a finally obtained output image is clearer. Even in a case of low illumination, a clearer image with higher brightness can be obtained.

Optionally, the nano antenna may generally include a material having a surface plasmon effect, such as gold, silver, or graphene. Generally, different bands may correspond to different materials. For example, silver may be selected as a material of the nano antenna for a visible light band, graphene may be selected as a material of the nano antenna for a far-infrared band, or a plurality of materials may be selected as materials of the nano antenna for a plurality of bands. This may be specifically selected based on an actual application scenario. This is not limited in this application.

Optionally, there is a positive correlation relationship between a thickness of a nano antenna included in each nano antenna layer and a wavelength of a plasmon signal or an output signal generated by each layer of nano antenna. To be specific, a larger thickness of the nano antenna indicates a larger wavelength of the plasmon signal generated by the nano antenna, and a smaller thickness of the nano antenna indicates a smaller wavelength of the plasmon signal generated by the nano antenna. For example, as shown in FIG. 3, thicknesses of the nano antennas included in the plurality of nano antenna layers from top to bottom gradually increase, and correspondingly, wavelengths of the generated plasmon signals gradually increase.

Optionally, the nano antennas included in each nano antenna layer may have a same thickness, to be specific, the nano antennas that absorb different bands may have a same thickness, but may have different plane sizes, different plane shapes, or the like. For example, there may be also a positive correlation relationship between a size of an antenna and a wavelength absorbed by the antenna. Specifically, a proper shape or size may be selected based on an actual application scenario.

It should be noted that, in this implementation of this application, for ease of understanding, an incident direction of incident light is understood as a direction from top to bottom. Details are not described below again.

Optionally, the plurality of nano antenna layers in the image sensor may be arranged based on wavelengths of resonated incident light in the nano antenna layers. For example, in the direction from top to bottom, the nano antenna layers may be arranged in ascending order of absorption wavelengths (namely, wavelengths of resonated incident light). For example, an absorption wavelength of a nano antenna arranged in a nano antenna layer arranged above is greater than or equal to an absorption wavelength of a nano antenna in a nano antenna layer arranged below. In other words, the absorption wavelength of the nano antenna layer arranged below is less than or equal to the absorption wavelength of the nano antenna in the nano antenna layer arranged below. Certainly, the nano antenna layers may alternatively be arranged in descending order of absorption wavelengths. For example, an absorption wavelength of a nano antenna layer arranged above is less than or equal to an absorption wavelength of a nano antenna layer arranged below.

Generally, there is a positive correlation relationship between a thickness of an antenna layer and an absorption wavelength of an antenna. For example, if an absorption wavelength of a nano antenna in a nano antenna layer arranged above is greater than an absorption wavelength of a nano antenna in a nano antenna layer arranged below, a thickness of the nano antenna layer arranged above is greater than a thickness of the nano antenna layer arranged below.

Generally, nano antennas of different sizes and different shapes may correspond to different resonant light wavelengths. When incident light is incident to a nano antenna, a plasmon signal is generated on a surface of the nano antenna due to a plasmon effect. Generally, a wavelength of the plasmon signal generated on the surface of the nano antenna is less than a wavelength of transmitted light. For example, the wavelength of the plasmon signal is generally 1/6-1/2 of the wavelength of the light, which specifically depends on a material used by the nano antenna. A length of the nano antenna is generally less than the wavelength of the light, for example, may be determined based on the wavelength of the plasmon signal on the surface of the nano antenna. For example, there is a positive correlation relationship between the wavelength of the plasmon signal on the surface of the nano antenna and the length of the nano antenna. For example, if the nano antenna is a dipole antenna, a length of the dipole antenna may be generally 1/2 of a wavelength received by the dipole antenna. Therefore, the length of the dipole antenna may be 1/2 of the wavelength of the plasmon signal.

For example, a nano antenna layer of a color image sensor may be divided into a plurality of structures, and may be disposed from top to bottom to absorb blue, green, and red light. To enable a nano antenna to implement a proper resonant response band, a size and a shape of the nano antenna may be set. For example, response bands of nano antennas from top to bottom may be 400 nm to 500 nm, 500 nm to 600 nm, and 600 nm to 700 nm respectively, and corresponding nano antennas may be square gold nano antennas with a side length of 200 nm, 240 nm, and 280 nm respectively.

In addition, a width of an antenna also affects a band of a signal to which the antenna responds. For example, there may be a positive correlation relationship between the width of the antenna and a width of a band of a wavelength absorbed by the antenna. For example, a greater width of a nano antenna indicates a wider band of incident light for which the nano antenna generates resonance. Therefore, the width of the antenna may be adjusted based on a band to which the antenna needs to respond. For example, in some application scenarios, an antenna shape with a specific width may be selected, for example, a tie shape, a square shape, or a circle shape. Specifically, a proper antenna shape may be selected based on an actual application scenario.

In some scenarios, different nano antenna layers may generate resonance for light of different bands or different polarizations, and a plasmon signal is generated on a surface of a nano antenna. For example, a first nano antenna layer may generate resonance for light that is of a band a and a resonance direction A, and a second nano antenna layer may generate resonance for light that is of the band a and a polarization direction B. Alternatively, a first nano antenna layer may generate resonance for light of a band a, and a second nano antenna layer may generate resonance for light of a band b. Therefore, a plurality of nano antenna layers may be disposed to increase coverage of a frequency band received by the photosensitive pixel, so that the image sensor can collect more information in a scenario, and quality of a finally output image is improved.

In addition, the nano antenna has a polarization resonance characteristic, and can implement sensing of different antenna layers for different polarized light. For example, a polarization direction of a dipole antenna is linear polarization, which is consistent with an extension direction of the antenna, and a polarization direction of a spiral antenna is circular polarization, which is consistent with a rotation direction of the antenna. Generally, when a polarization direction of the incident light is consistent with a polarization direction of the nano antenna, absorption of the incident light by the nano antenna is improved. Therefore, in this implementation of this application, different antenna layers may be disposed to absorb incident light that is of a same band but different polarization directions. For example, a nano antenna of a polarization direction A may be disposed at an upper layer, and a nano antenna of a polarization direction B may be disposed at a lower layer, so that light of different polarizations can be more effectively absorbed. Generally, for the light that is of a same band but different polarizations, a thickness of a lower nano antenna layer is greater than a thickness of an upper nano antenna layer. It may be understood that, when light of a same band passes through the upper layer, a part of the light is absorbed. To maintain absorption balance of the two layers, the thickness of the lower nano antenna layer may be increased, so that sensing intensity of the nano antenna layers that absorb the incident light that is of a same band but different polarizations is closer.

In addition, antenna layers that absorb the light that is of a same band but different polarization directions may generally be adjacent nano antenna layers, so that thickness distribution of the nano antenna layers is more uniform, and absorption intensity of each nano antenna layer is closer.

For example, as shown in FIG. 4, if the nano antennas are tie-shaped antennas, polarization directions of an upper-layer nano antenna and a lower-layer nano antenna are different. The polarization directions of the upper-layer antenna and the lower-layer antenna that are shown in FIG. 4 are perpendicular to each other.

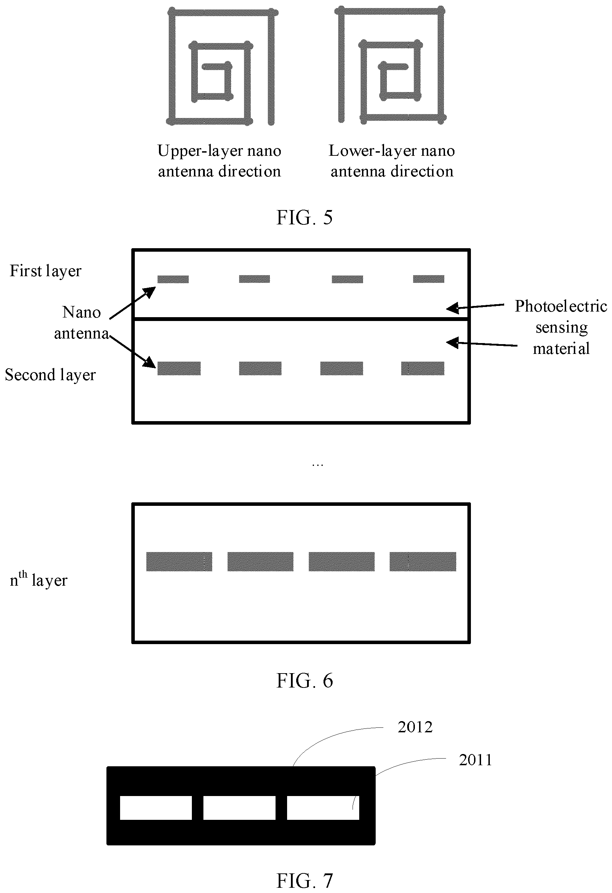

For another example, as shown in FIG. 5, the nano antennas may be spiral antennas, and rotation directions of the upper-layer antenna and the lower-layer antenna are different. For example, the upper-layer antenna uses a clockwise rotation direction, and the lower-layer antenna may use a counterclockwise rotation direction.

Generally, the plasmon signal generated by the nano antenna may be converted into an electrical signal through the photoelectric sensing material. The photoelectric sensing material may be added to the nano antenna layer. Alternatively, the plasmon signal generated by the nano antenna is converted into an electrical signal through a photoelectric sensing layer including the photoelectric sensing material, and then is output through a pin.

When the photoelectric sensing material is added to the nano antenna layer, the photoelectric sensing material included in the nano antenna layer may directly convert the plasmon signal generated on the surface of the nano antenna into an electrical signal, and the electrical signal is output through a pin. It may be understood that the nano antenna is coupled in the photoelectric sensing material, and photosensibility is enhanced through the nano antenna, so that a thickness of the photoelectric sensing material is reduced, and crosstalk is reduced by improving light selectivity. When the photoelectric sensing layer is disposed separately, the plasmon signal generated on the surface of the nano antenna may be converted into an electrical signal through the photoelectric sensing layer, and is output through a pin.

Different photoelectric sensing materials may be used for different bands. For example, in a visible light or near-infrared band, the photoelectric sensing material may be silicon, and in a mid- and far-infrared band, the photoelectric sensing material may be InGaAs or the like. Specifically, a matched photoelectric sensing material may be selected based on an actual application scenario. This is not limited in this application.

The following separately describes different disposing manners of the photoelectric sensing material.

### 1. Adding the photoelectric sensing material to a nano antenna layer

A photoelectric sensing structure may be disposed at the nano antenna layer. The photoelectric sensing structure includes the photoelectric sensing material for photoelectric conversion, that is, the photoelectric sensing material is used to convert a plasmon signal on a surface of the nano antenna into an electrical signal. The photoelectric sensing structure is in contact with at least one surface of nano antennas in a nano antenna layer. For example, the photoelectric sensing structure may be in contact with one surface of the nano antennas, or the photoelectric sensing structure wraps the plurality of nano antennas.

Specifically, a structure of a photosensitive pixel may be shown in FIG. 6. The photosensitive pixel may include n nano antenna layers, and the photoelectric sensing material may be disposed in the nano antenna layers, to convert, through photoelectric sensing, a plasmon signal generated by nano antennas into an electrical signal.

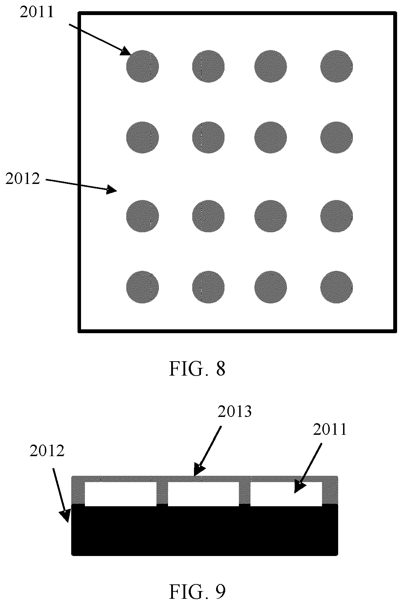

For example, a structure of one of the nano antenna layers may be shown in FIG. 7. The nano antenna layer may include nano antennas 2011 and a photoelectric sensing structure 2012. The photoelectric sensing structure 2012 includes a photoelectric sensing material. The photoelectric sensing material wraps the nano antennas 2011. For example, a top view of one of the nano antenna layers may be shown in FIG. 8. The nano antennas may be arranged to form an array, and the photoelectric sensing material wraps the nano antennas, so that the plasmon signal can be fully converted into an electrical signal.

For example, another structure of the nano antenna layer may be shown in FIG. 9. The nano antenna layer may include nano antennas 2011, a photoelectric sensing structure 2012, and a filling structure 2013. The nano antennas 2011 are disposed on an upper layer of the photoelectric sensing structure 2012, and lower surfaces of the nano antennas 2011 are in contact with the photoelectric sensing structure 2012. To fasten the nano antennas 2011, the filling structure 2013 may be disposed between the nano antennas 2011, that is, a filling medium is used to fill a gap between the nano antennas. The filling medium may be a medium of a transparent material, to fasten the nano antennas and avoid movement of the nano antennas in the nano antenna layer. The photoelectric sensing structure is in contact with the nano antennas, to convert the plasmon signal generated on the surfaces of the nano antennas into an electrical signal.

Generally, light of different wavelengths has different penetration depths for a specific photoelectric sensing material. For example, in silicon, thicknesses of silicon needed for absorbing 95% of vertically incident blue, green, and red light are respectively close to 1 micrometer, 3 micrometers, and 9 micrometers. However, due to the plasmon effect on the surfaces of the nano antennas, the incident light can be strongly focused, the needed thickness of the photoelectric sensing material can be greatly reduced. For example, after the nano antennas are added, the thicknesses of silicon that achieves the above 95% absorption of blue, green, and red light may be reduced to only 0.3 micrometer, 1 micrometer, and 3 micrometers. Therefore, a thickness of a silicon layer can be reduced, consumption of a material can be reduced, and the obtained nano antenna layer is more flexible. In addition, for light that is not resonated by the nano antennas at the current layer, unnecessary absorption is also greatly reduced, crosstalk is reduced, and crosstalk light intensity may be reduced to 1/3 or even lower of the original intensity.

In addition, because light of different wavelengths has different penetration depths, for most application scenarios, a nano antenna layer above is generally relatively thin, and corresponds to a relatively short wavelength. However, it is also possible to enable layers to have a same thickness for a specific application, for example, to enhance absorption of light of a short wavelength.

Optionally, to enhance the plasmon effect on the surfaces of the nano antennas and further reduce the needed thickness of the photoelectric sensing material, the nano antenna layer may be divided into a plurality of nano antenna sublayers. The plurality of nano antenna sublayers perform resonance on the same incident light. Each nano antenna sublayer may include a plurality of nano antennas. When a distance between the sublayers is less than a specific range, for example, less than 50 nm, the sublayers may interact with each other to form energy coupling and further enhance absorption.

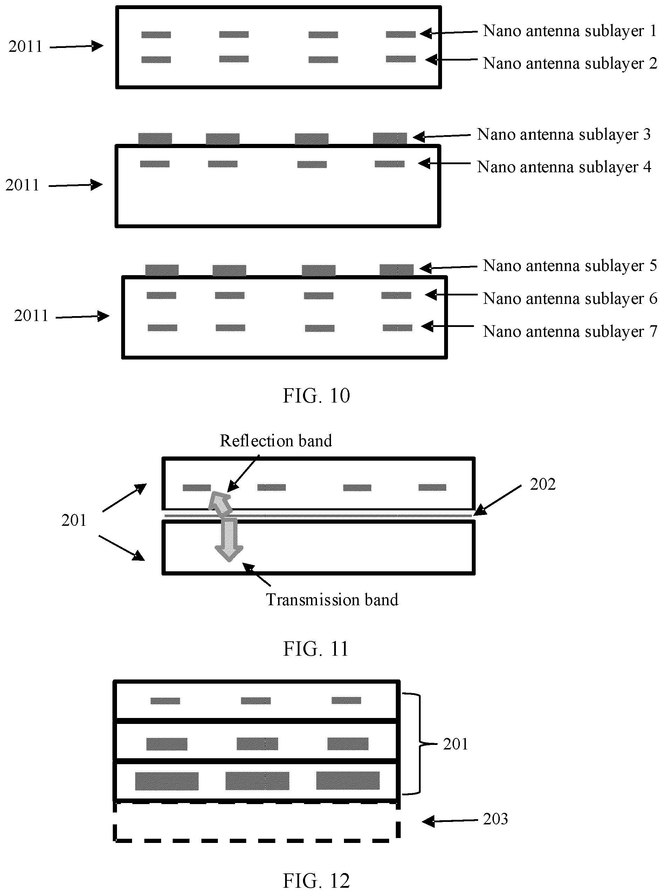

For example, as shown in FIG. 10, each nano antenna layer 2011 may include a plurality of nano antenna sublayers. As shown in FIG. 8, a first nano antenna layer may include a nano antenna sublayer 1 and a nano antenna sublayer 2, a second nano antenna layer may include a nano antenna sublayer 3 and a nano antenna sublayer 4, and a third nano antenna layer may include a nano antenna sublayer 5, a nano antenna sublayer 6, and a nano antenna sublayer 7. In addition, in structures of the second nano antenna layer and the third nano antenna layer, the nano antenna sublayer 3 and the nano antenna sublayer 5 are respectively in contact with the photoelectric sensing structures on the photoelectric sensing structures. It may be understood as nano antennas placed inside the photoelectric sensing structure and nano antennas placed on the photoelectric sensing material may be separately considered as a nano antenna sublayer.

In an optional implementation, a selection layer may be disposed between adjacent nano antenna layers, and is configured to filter light transmitted between the adjacent nano antenna layers, to filter out, to some extent, light of a specific wavelength that is transmitted to a next nano antenna layer, thereby avoiding crosstalk caused to receiving of light of the next nano antenna layer.

Two adjacent nano antenna layers are used as an example. For ease of differentiation, the two adjacent nano antenna layers are a first nano antenna layer and a second nano antenna layer. The first nano antenna layer absorbs light of a first band. The second nano antenna layer absorbs light of a second band. A selection layer may be disposed between the first nano antenna layer and the second nano antenna layer. Incident light is transmitted to the second nano antenna layer after passing through the first nano antenna layer. The selection layer may reflect the light of the first band and transmit the light of the second band. When there is another nano antenna layer below the second nano antenna layer, the selection layer further transmits light of a band absorbed by the another nano antenna layer below the second nano antenna layer. It may be understood that the selection layer may reflect light of a band absorbed by a nano antenna layer above the selection layer, and transmit light of a band absorbed by a nano antenna layer below the selection layer, to avoid crosstalk caused by the band corresponding to the upper nano antenna layer to the lower nano antenna layer, and improve quality of a finally output image.

Specifically, a selection layer disposed in two adjacent nano antenna layers may be shown in FIG. 11. The selection layer 202 is additionally disposed between the two adjacent nano antenna layers 201. A material of the selection layer may include at least two materials with different refractive indexes, and at least one of the materials has a transmission characteristic. For example, the selection layer may include metal and another material with a different refractive index. Alternatively, the selection layer may include two types of media with different refractive indexes, for example, media such as silicon dioxide and silicon nitride in a visible light band. A reflection surface and a transmission surface that have a frequency selection function are implemented through an array structure, so that a phase difference is generated for incident light through materials with different refractive indexes, and the selection layer can reflect light in a specific band range and transmit light in another band range. In addition, there may be one or more selection layers. This can be specifically adjusted based on an actual application scenario.

Two layers are used as an example, for example, an i^{th} nano antenna layer and an (i+1)^{th} nano antenna layer. A selection layer is additionally disposed between the i^{th} nano antenna layer and the (i+1)^{th} nano antenna layer. The selection layer may include three layers of nanoparticles. The nanostructure particles are silver nanoparticles. A support material may be P-SF68 glass. A spacing of the first layer of particles is 17 nanometers, and a diameter of the first layer of particles is 13 nanometers. A spacing of the second layer of particles is 34 nanometers, and a diameter of the second layer of particles is 26 nanometers. A spacing of the third layer of particles is 17 nanometers, and a diameter of the third layer of particles is 13 nanometers. A simulation result shows that this structure can selectively reflect a spectrum from 505 nm to 610 nm and transmit another band. A size of the silver nanoparticles is far less than a wavelength of incident light, and is also far less than a size of nano antennas. The silver nanoparticles are mainly used for light selection.

Therefore, in this implementation of this application, a thickness of the photoelectric absorption material is greatly reduced through a strong focusing function of the nano antennas, thereby reducing absorption of crosstalk light. Further, a wavelength selection function of the nano antennas also reduces the absorption of crosstalk light, thereby achieving an effect of greatly reducing crosstalk. In addition, due to the strong focusing function of the nano antennas, a light absorption function is enhanced, and photosensibility is improved. Even in a case of low illumination, a clearer image with higher brightness can be finally obtained.

### 2. Separately disposing the photoelectric sensing layer

The photoelectric sensing layer that is disposed separately may be shown in FIG. 12. The photoelectric sensing layer 203 may be disposed in an image sensor. The photoelectric sensing layer may be disposed below a plurality of nano antenna layers. The photoelectric sensing layer may include a photoelectric sensing structure for photoelectric sensing, and is configured to convert a plasmon signal generated on a surface of nano antennas into an electrical signal.

In this implementation, in addition to the nano antennas, the nano antenna layer may be filled by using a transparent medium to improve stability of the nano antennas, so that incident light can pass through the current layer and be transmitted to a next layer.

Specifically, the nano antennas are connected to the photoelectric sensing layer through a waveguide, so that the plasmon signal is transmitted to the photoelectric sensing layer through the waveguide. One ends of the plurality of nano antennas included in each nano antenna layer are connected to one end of the waveguide, and the other end of the waveguide is connected to the photoelectric sensing layer. The waveguide may pass through one or more nano antenna layers. Plasmon signals generated by the plurality of nano antennas are transmitted to the photoelectric sensing layer through the waveguide.

For example, the nano antennas are dipole antennas. As shown in FIG. 12, inner side ends of two oscillators of the nano antenna are respectively connected to one ends of two segments of a waveguide, the waveguide may pass through one or more nano antenna layers, and the other ends are connected to the photoelectric sensing layer. A plurality of photoelectric sensing units may be disposed in the photoelectric sensing layer. Each nano antenna may correspond to one photoelectric sensing unit. The waveguides connected to each nano antenna are connected to the photoelectric sensing unit corresponding to the nano antenna, and transmit, to the photoelectric sensing unit, a plasmon signal generated on a surface of the nano antenna. The photoelectric sensing unit converts the plasmon signal into an electrical signal.

A material of the waveguide may be the same as that of the nano antenna. Alternatively, a material that is different from that of the nano antenna and that can be used to transmit the plasmon signal may be selected. The material of the waveguide may be a semiconductor material with a wide band gap, for example, zinc oxide, to reduce light absorption in a transmission process.

Generally, a transmission loss of a relatively long wavelength in the waveguide is relatively low. Therefore, a nano antenna with a relatively long wavelength may be generally disposed at an upper layer. That is, the nano antenna layers may be arranged in descending order of absorption wavelengths. For example, a thickness of the nano antenna layer arranged above is not greater than a thickness of the nano antenna layer arranged below. In addition, a wavelength corresponding to the nano antennas in the nano antenna layer arranged above is not greater than a wavelength corresponding to the nano antennas in the nano antenna layer arranged below. Specifically, for example, lengths of waveguides connected to the nano antennas corresponding to red, green, and blue may be 200 nm, 100 nm, and 50 nm respectively.

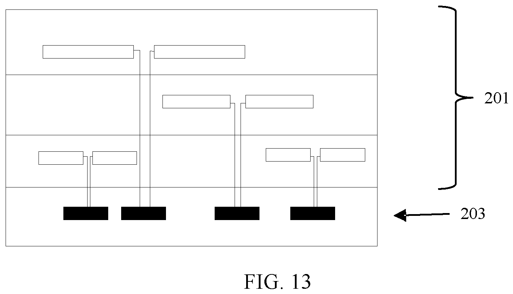

In addition, to avoid a coupling effect between the nano antennas, there is generally a specific spacing between the nano antennas at different layers. Optionally, a vertical distance between nano antennas included in two adjacent nano antenna layers of the plurality of nano antenna layers is not less than one tenth of a wavelength of light absorbed by the two adjacent nano antenna layers. That is, the spacing between the nano antennas at different layers is usually greater than at least 1/10 of a wavelength of the light absorbed by the nano antennas, namely, the resonated incident light. For example, the spacing between the nano antennas at the layers may be generally set to at least 50 nm. To further reduce a height between the nano antenna layers, for non-circular nano antennas, the same-shaped nano antennas at adjacent layers may be staggered at different angles, to increase the spacing. As shown in FIG. 13, the upper-layer nano antenna and the lower-layer nano antenna may include cross-shaped nano antennas. The lower-layer nano antenna rotates 45 degrees relative to the adjacent upper-layer nano antenna. The height between the layers is reduced, so that a waveguide length may be shortened, and a propagation loss is reduced.

For the image sensor provided above, this application further provides a manufacturing method for the image sensor. The method may specifically include: manufacturing nano antenna layers layer by layer. If a photoelectric sensing material is disposed in each layer of nano antennas, when the nano antenna layers are manufactured layer by layer, the nano antennas and the photoelectric sensing material are prepared in each layer of nano antennas. If a photoelectric sensing layer is separately disposed, when the nano antenna layers are manufactured layer by layer, a plurality of nano antennas, a filling medium, and waveguides may be prepared in each nano antenna layer. The waveguides span and are connected to the nano antennas. The waveguides span a plurality of layers and are connected to the photoelectric sensing layer. Further, the photoelectric sensing layer is prepared by using the photoelectric sensing material. Photoelectric sensing units are prepared in each photoelectric sensing layer. The photoelectric sensing units are connected to the waveguides. Photosensitive pixels are arranged into an array after being manufactured. Row pins and column pins are separately disposed for the array.

The foregoing descriptions are merely optional embodiments of this application, but not intended to limit this application. Any modification, equivalent replacement, improvement, or the like made without departing from the spirit and principle of this application should fall within the protection scope of this application.

## Claims

1. An image sensor, comprising at least one photosensitive pixel, wherein
each photosensitive pixel comprises a plurality of nano antenna layers, the plurality of nano antenna layers are arranged in an overlapping manner, each nano antenna layer comprises at least one nano antenna, the at least one nano antenna is configured to generate resonance for incident light, nano antennas in the different nano antenna layers are configured to generate resonance for different incident light, and an output signal of the nano antenna is used to obtain an image.

2. The image sensor according to claim 1, wherein the image sensor further comprises a plurality of pins, the plurality of pins are in contact with the at least one photosensitive pixel, the plurality of pins are configured to receive an electrical signal output by the at least one photosensitive pixel, and the electrical signal is used to obtain an image.

3. The image sensor according to claim 1 or 2, wherein that the at least one nano antenna is configured to generate resonance for incident light comprises: the at least one nano antenna is configured to generate resonance for the incident light to generate a plasmon signal, wherein the plasmon signal is used to generate an electrical signal.

4. The image sensor according to any one of claims 1 to 3, wherein each nano antenna layer further comprises a photoelectric sensing structure, the photoelectric sensing structure is in contact with at least one surface of the at least one nano antenna, and the photoelectric sensing structure is configured to convert the output signal of the at least one nano antenna into an electrical signal.

5. The image sensor according to claim 4, wherein a selection layer is further disposed between adjacent nano antenna layers of the plurality of nano antenna layers, and the selection layer is configured to filter light transmitted between the adjacent nano antenna layers.

6. The image sensor according to claim 5, wherein the selection layer is disposed in a first nano antenna layer and a second nano antenna layer, the first nano antenna layer and the second nano antenna layer are two adjacent layers of the plurality of nano antenna layers, a transmission direction of the incident light is that the incident light passes through the first nano antenna layer and is transmitted to the second nano antenna layer, the selection layer comprises at least two materials with different refractive indexes, the selection layer is configured to reflect light of a first band and transmit light of a second band, the first band is a band of resonated incident light in the first nano antenna layer, and the second band is a band of resonated incident light in the second nano antenna layer.

7. The image sensor according to any one of claims 4 to 6, wherein each nano antenna layer comprises a plurality of nano antenna sublayers, each nano antenna sublayer comprises at least one nano antenna, and the plurality of nano antenna sublayers generate resonance for incident light of a same band.

8. The image sensor according to any one of claims 1 to 3, wherein the image sensor further comprises a photoelectric sensing layer, the photoelectric sensing layer is disposed below the plurality of nano antenna layers, and the photoelectric sensing layer is configured to convert an output signal generated by the plurality of nano antenna layers into an electrical signal.

9. The image sensor according to claim 8, wherein one end of the at least one nano antenna comprised in each nano antenna layer is connected to one end of a waveguide, the other end of the waveguide is connected to the photoelectric sensing layer, and the output signal generated by the at least one nano antenna is transmitted to the photoelectric sensing layer through the waveguide.

10. The image sensor according to claim 8 or 9, wherein a vertical distance between nano antennas comprised in two adjacent nano antenna layers of the plurality of nano antenna layers is greater than or equal to one tenth of a wavelength of resonated incident light in any one of the two adjacent nano antenna layers.

11. The image sensor according to any one of claims 1 to 10, wherein in two adjacent nano antenna layers of the plurality of nano antenna layers, a thickness of a nano antenna layer arranged above is less than or equal to a thickness of a nano antenna layer arranged below.

12. The image sensor according to any one of claims 1 to 11, wherein a wavelength of resonated incident light in the nano antenna layer arranged above is less than or equal to a wavelength of resonated incident light in the nano antenna layer arranged below.

13. The image sensor according to any one of claims 1 to 10, wherein in two adjacent nano antenna layers of the plurality of nano antenna layers, a wavelength of incident light for which a nano antenna in a nano antenna layer arranged above generates resonance is greater than a wavelength of incident light for which a nano antenna in a nano antenna layer arranged below generates resonance.

14. The image sensor according to any one of claims 1 to 13, wherein there is a positive correlation relationship between a thickness of the nano antenna comprised in each nano antenna layer and a wavelength of the output signal of each nano antenna layer.

15. The image sensor according to any one of claims 1 to 14, wherein antennas that are of a same shape and that are comprised in two adjacent nano antenna layers have different polarization directions.

16. The image sensor according to claim 15, wherein
if the at least one nano antenna is a dipole antenna, dipole antennas in two adjacent nano antenna layers have different extension directions; or
if the at least one nano antenna is a spiral antenna, spiral antennas in two adjacent nano antenna layers have different rotation directions.

17. An electronic device, wherein the electronic device comprises the image sensor according to any one of claims 1 to 16.
